Europäisches Patentamt

European Patent Office

Office européen des brevets

(11) Publication number: 0 517 375 A2

# EUROPEAN PATENT APPLICATION

(21) Application number: 92304077.8

(22) Date of filing: 06.05.92

(51) Int. Cl.5: H03K 19/003, G05F 1/46

(30) Priority: 06.06.91 JP 162123/91

(43) Date of publication of application:
09.12.92 Bulletin 92/50

(84) Designated Contracting States:
DE FR GB IT

(71) Applicant: HITACHI, LTD.
6, Kanda Surugadai 4-chome
Chiyoda-ku, Tokyo 101(JP)

(72) Inventor: Noda, Takaaki
2-3-11-105, Misumi-cho
Higashimurayama-shi, Tokyo(JP)
Inventor: Hagiwara, Shiro
4-2-21, Mukouhara
Higashiyamato-shi, Tokyo(JP)

(74) Representative: Calderbank, Thomas Roger et al
MEWBURN ELLIS 2 Cursitor Street
London EC4A 1BO(GB)

(54) Semiconductor integrated circuit device.

(57) According to the voltage which is obtained by allowing a current to flow in a dummy circuit equivalent to a digital circuit, or according to the output of a phase/frequency comparator circuit, the operating voltage of a ring oscillator having an inverter circuit equivalent to the digital circuit is so generated that the oscillation frequency of the ring oscillator is equal to a reference frequency. The digital circuit is operated on this operating voltage. This semiconductor integrated circuit device is further mounted on a signal processing device that is operated by a battery incorporated therein.

The digital circuit operates on the same current as the current flowing in the dummy circuit and at the same operation speed as that of the ring oscillator stably and consuming the electric power in an optimum way. By using such a digital circuit, it is allowed to obtain a signal processing device that enables the life of the battery power source to be prolonged.

FIG. 1

The present invention relates to a semiconductor integrated circuit device and to a signal processing device. More specifically, the invention relates to a technology that can be effectively utilized for signal processing devices which operate, for example, on battery voltage and for semiconductor integrated circuit devices mounted thereon.

In order to obtain a semiconductor integrated circuit device of low power consumption, it has been proposed to lower the operation voltage through an internal step-down circuit in the case of dynamic RAMs (random access memories). In the case of static RAMs having polysilicon resistances, a technology has been proposed according to which a negative temperature coefficient is imparted to an internal power source regulator in order to stabilize the consumption of current by the polysilicon resistance that has a negative temperature coefficient as disclosed in, for example, Japanese Patent Laid-Open No. 127596/1985.

In mobile wireless communication devices such as portable telephone sets operated on cell voltage, in recent years, it has been desired to reduce the consumption of the electric power and to stabilize the operation. In such a mobile wireless communication device, the system is constituted by the mixture of analog circuits and digital circuits. In analog circuits, various contrivances are made for the bias circuit to reduce the consumption of electric power and to stabilize the characteristics. Digital circuits, on the other hand, are usually designed with margin taking into consideration the process variances so that desired specifications such as the speed out of the conditions under which the device is operated can be satisfied. Therefore, the consumption of electric power is far from reduced and the operation is far from stabilized in spite of using the above-mentioned internal step-down circuit and the power source regulator having temperature dependency.

Generally, a cell has a capacity having a feature such that the output current is small at low temperatures and large at high temperatures according to the characteristics of the cell. In a digital circuit, on the other hand, the conductances of MOSFETs are large at low temperature and accordingly the operation speed is high causing the consumption of electric power to be large, and the conductances of MOSFETs is small at high temperature and the operation speed is low causing the consumption of electric power to be small. Because of these conflicting features, a device doing cell operation encounters problems of reducing the consumption of electric power by digital circuits and of stabilizing the operation.

The object of the present invention is to provide a semiconductor integrated circuit device realizing the reduction in the consumption of electric power by the digital circuit and the stabilization of the operation.

Another object of the present invention is to provide a signal processing device including a digital circuit which is suited to the cell operation.

The above and other objects as well as novel features of the present invention will become obvious from the description of the specification and the accompanying drawings.

Among the inventions disclosed in this application, a representative example will be briefly described below. According to the voltage which is obtained by allowing a current to flow in a dummy circuit equivalent to a digital circuit, or according to the output of a phase/frequency comparator circuit, the operating voltage of a ring oscillator having an inverter circuit equivalent to the digital circuit is so generated that the oscillation frequency of the ring oscillator is equal to a reference frequency. The digital circuit is operated on this operating voltage. Furthermore, the above semiconductor integrated circuit device is mounted on a signal processing device that is powered by a battery contained therein.

By using the above-mentioned means, an electric current flows in the digital circuit which is the same as the electric current that flows in the dummy circuit or the ring oscillator, or the operation speed of the digital circuit is controlled in correspondence with the operation speed of the ring oscillator. Therefore, the consumption of electric power by the digital circuit is optimized and stabilized. Use of such a digital circuit makes it possible to obtain a signal processing device that can be powered by a battery source for a long period of time.

**In the drawings:**

Fig. 1 is a circuit diagram illustrating a fundamental embodiment according to the present invention;

Fig. 2 is a circuit diagram illustrating another embodiment of the present invention;

Fig. 3 is a circuit diagram illustrating an example of a constant-current generating circuit;

Fig. 4 is a diagram showing the temperature dependency of the output voltage of the power source regulator shown in Fig. 1;

Fig. 5 is a circuit diagram illustrating a further embodiment of the present invention;

Fig. 6 is a diagram of waveforms for explaining the operation of the embodiment of Fig. 5;

Fig. 7 is a circuit diagram illustrating an example of a reference frequency signal generating circuit;

Fig. 8 is a block diagram illustrating an example of a signal processing device according to the present invention; and

Fig. 9 is a block diagram illustrating an example of major portions of a digital cordless telephone set to which the present invention is applied.

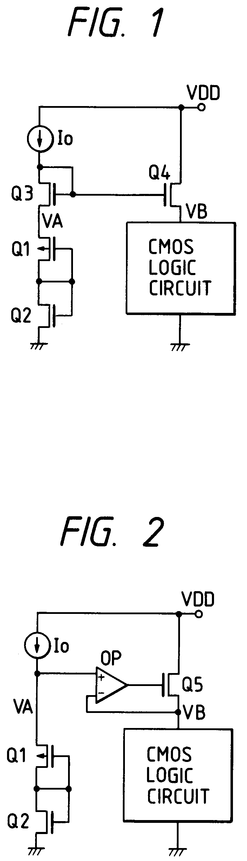

Fig. 1 is a circuit diagram illustrating a fundamental embodiment of the present invention wherein the circuit elements and the circuit blocks are formed on a semiconductor substrate such as of single crystal silicon by a widely known technology of fabricating CMOS integrated circuits. In Fig. 1, a MOSFET (insulated gate field-effect transistor) to a channel (backgate) portion of which an arrow is given is of a p-channel type.

An integrated circuit is formed on a semiconductor substrate made of single crystal p-type silicon. The n-channel MOSFET is constituted by a source region and a drain region formed on the surface of the semiconductor substrate, and by a gate electrode made of polysilicon formed on the surface of a semiconductor substrate between the source region and the drain region via a thin gate insulating film. The p-channel MOSFET is formed on an n-type well region that is formed on the surface of the semiconductor substrate. Thus, a substrate gate which is common to a plurality of n-channel MSOFETs is formed on the semiconductor substrate to feed the ground potential of the circuit. The n-type well region constitutes a substrate gate of the p-channel MOSFET formed thereon. The substrate gate, i.e., the n-type well region of the p-channel MOSFET is coupled to a power source voltage VDD. The substrate gate of the n-channel MOSFET is served with ground potential of the circuit.

Instead of the above-mentioned constitution, the integrated circuit may be formed on a semiconductor substrate made of single crystal n-type silicon. In the case, the n-channel MOSFETs and the non-volatile memory elements are formed on the p-type well regions, and the p-channel MOSFETs are formed on the n-type substrate.

A p-channel MOSFET Q1 and an n-channel MOSFET Q2 which are connected in series with their gates in common are constituted by the same MOSFETs and in the same circuit constitution as those of an inverter circuit which is a basic gate in a CMOS logic circuit. The input and output are coupled together. Therefore, the CMOS inverter circuit consisting of the MOSFETs Q1 and Q2 is placed under the condition that the input signal is equal to the output signal, and the largest through current (DC current) flows. The MOSFETs Q1 and Q2 are used as a dummy circuit of the CMOS logic circuit, and their gates and drains are connected in common, so that a constant current Io is supplied as an operating current via an n-channel MOSFET Q3 connected in the form of a diode which shifts the level. That is, a through current which corresponds to the constant current Io formed by a constant-current source is caused to flow forcedly through the CMOS inverter circuit (Q1 and Q2) that constitutes the dummy circuit.

The operation speed of the CMOS logic circuit (digital circuit) is determined chiefly by the drive current of the MOSFETs and the load capacitance. The drive current of the CMOS inverter circuit is represented by a through current of when the input voltage is near a logical threshold voltage of the inverter circuit. Here, since the p-channel MOSFET and the n-channel MOSFET both operate in the saturation regions, the following relationship (1)

$$I = (VDD - VTP - VTN)^2/(2(1/SQRT(\beta_P)) + 1/SQRT(\beta_N))^2) \qquad (1)$$

holds among the through current I, power source voltage VDD, threshold voltage VTP of the p-channel MOSFET, threshold voltage VTN of the n-channel MOSFET, channel conductance $\beta_P$ of the p-channel MOSFET, and channel conductance $\beta_N$ of the n-channel MOSFET, wherein $SQRT(\beta_P)$ is equal to $(\beta_P)^{1/2}$ and, similarly, $SQRT(\beta_N)$ is equal to $(\beta_N)^{1/2}$.

It will be understood from the above relationship that the through current I increases in proportion to the square of the difference between the sum (VTP + VTN) of the threshold voltages of the p-channel MOSFET and n-channel MOSFET and the power source voltage VDD. Though the VTP and VTN have negative temperature coefficients, and the $\beta_P$ and $\beta_N$ have negative temperature coefficients, the through current of the semiconductor integrated circuit device which operates on a power source voltage of 5 volts decreases with an increase in the temperature under the condition where the power source voltage VDD remains constant. Of the semiconductor integrated circuit device, the load capacitance is the wiring capacitance or the gate capacitance which are fixed ones. Therefore, the change in the through current determines the operation speed of the digital circuit.

In the CMOS inverter circuit constituting a dummy circuit shown in Fig. 1, therefore, the through current is forcedly set to be a constant current Io and a voltage VA is so generated that the through current Io flows. The voltage VA is found from the following relationship (2),

$$VA = (VTP + VTN)SQRT(2Io(1/SQRT(\beta_P)) + 1/SQRT(\beta_N)) \qquad (2)$$

The level of the voltage VA is shifted by a threshold voltage across the gate and the source of the level-shifting MOSFET Q3, and is transmitted to the gate of the MOSFET Q4 in the form of source follower. The MOSFET Q4 has a drain which is supplied with the power source voltage VDD and a source to which the CMOS logic circuit is connected. In other words, the operation voltage VA of the CMOS inverter circuit (Q1 and Q2) constituting the dummy circuit is raised by the amount of a threshold voltage of the MOSFET Q3, lowered by the amount of the threshold voltage of the MOSFET Q4, and is transmitted as operation voltage VB to the CMOS logic circuit. The MOSFETs Q3 and Q4 can be regarded to be substantially equal to each other if their sizes are sufficiently increased, in other words, if they have necessary and sufficient current supplying abilities. Here, if the operation voltage VA of the above relationship (2) is substituted as VDD in the above relationship (1), there is obtained Io = I, and a through current Io whose value is the same as that of the constant current Io flowing in the dummy circuit flows in the CMOS inverter circuit that is provided in the CMOS logic circuit.

In a digital circuit such as the CMOS logic circuit as described above, the through current determines the operation speed of the digital circuit to affect the consumption of current. In this embodiment as described above, the through current in the CMOS logic circuit can be controlled by the constant current Io that flows in the CMOS inverter circuit (Q1 and Q2) which is the dummy circuit constituted by using the same MOSFETs. Thus, the time for charging or discharging the load capacitor becomes constant and accordingly the operation speed becomes constant in the CMOS inverter circuit and in the CMOS gate circuit of the CMOS logic circuit. Moreover, the consumption of electric power becomes constant since the operation speed becomes constant.

In the semiconductor integrated circuit device using a p-type substrate, it is desired to use the operation voltage VA or VB as the potential at the n-type well where the p-channel MOSFET is formed instead of using the power source voltage VDD in order to prevent the threshold voltage from being increased by the substrate bias effect. In order to widen the operation range of the power source voltage, furthermore, the n-channel MOSFETs Q3 and Q4 that work as a power source regulator of the CMOS logic circuit may have a low threshold voltage by implanting p-type impurity ions.

Fig. 2 is a circuit diagram of another embodiment of the present invention.

In this embodiment, a CMOS inverter circuit consisting of MOSFETs Q1 and Q2 used as a dummy circuit like the one described above is directly connected to a constant current source to permit a constant current Io to flow. The operation voltage VA generated by the dummy circuit is imputted into a voltage-follower consisting of an operational amplifier circuit OP and a source follower MOSFET Q5, and the output voltage VB thereof is used as an operation voltage of the CMOS logic circuit. That is, the gate of the MOSFET Q5 is served with an output signal of the operational amplifier circuit. The drain of the MOSFET Q5 is served with the power source voltage VDD. The source of the MOSFET Q5 is connected to the operation voltage terminal of the CMOS logic circuit and to the inverted input (-) of the operational amplifier circuit OP in a feedback loop. In this constitution, the operational amplifier circuit OP so controls the gate voltage of the MOSFET Q5 that the operation voltage VB of the CMOS logic circuit which is the feedback input becomes equal to the operation voltage VA that is generated by causing the constant current Io to flow in the dummy circuit. Like the embodiment of Fig. 1, therefore, the operation voltage VB of the CMOS logic circuit can be controlled by the operation voltage VA of the dummy circuit. In the power source regulator of this embodiment which uses the operational amplifier circuit, the operation voltage VB of the CMOS logic circuit can be brought into precise agreement with the operation voltage VA of the dummy circuit.

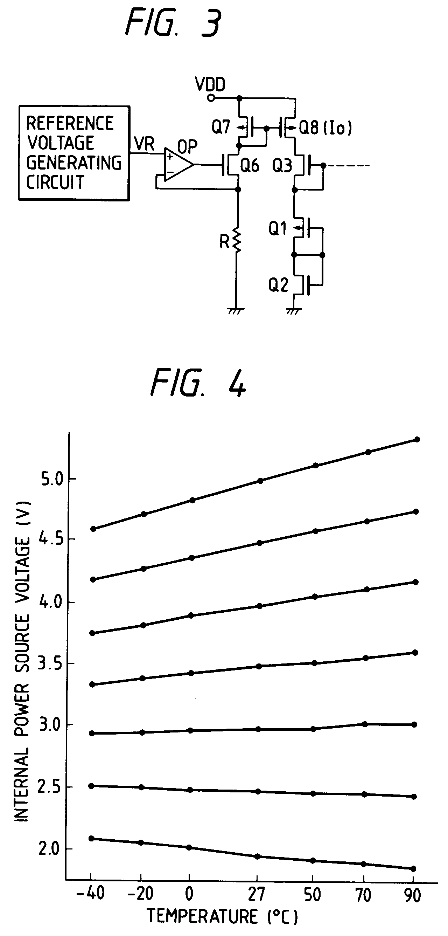

Fig. 3 is a circuit diagram illustrating an embodiment of a constant-current source circuit.

The constant-current source circuit of this embodiment supplies a constant current Io that flows in the dummy circuit. A reference voltage generating circuit generates a constant voltage VR which is applied to the resistor R through a voltage follower consisting of an operational amplifier circuit OP and a MOSFET Q6 like that of Fig. 2. Therefore, a constant current such as VR/R flows through the resistor R. A p-channel MOSFET Q7 in the form of a diode is directly connected to the MOSFET Q6 to allow a constant current restricted by the resistor R to flow through them. The MOSFET Q7 is provided with a MOSFET Q8 in the form of a current mirror in order to obtain a constant current Io from the MSOFET Q8. For instance, if the MOSFETs Q7 and Q8 have sizes of an equal ratio, the constant current Io flowing in the MOSFET Q8 becomes equal to the constant current flowing in the MOSFET Q7 or, in other words, equal to the constant current that is determined by the constant voltage VR and the resistor R. In the constitution of, for example, Fig. 1, the MOSFETs Q1 and Q2 constituting a dummy circuit is connected to the MOSFET Q8 via the MOSFET Q3. In the constitution of Fig. 2, furthermore, the MOSFETs Q1 and Q2 constituting the dummy circuit are directly connected to the MOSFET Q8.

The above constant voltage VR does not substantially vary depending upon the power source voltage or the temperature. It is therefore possible to generate a constant voltage VR on the basis of the difference in the threshold voltage between the n-channel MOSFET having a polysilicon gate in which are introduced p-type impurities and the n-channel MOSFET having a polysilicon gate in which are introduced n-type impurities, in other words, on the basis of the constant voltage generated by the use of the difference of silicon band gap, the constant voltage VR being stable against the change in the power source voltage and the temperature. It is further allowable to supply a constant current by using the threshold voltage of the MOSFET or the forward voltage of the pn-junction diode as a constant voltage VR and by selecting the resistance of the resistor R to be sufficiently great with respect to the constant voltage VR. In this case, if the resistor R is an externally connected one, there is obtained a constant current whose temperature dependency can be substantially neglected and a desired constant current Io is obtained with high precision.

Fig. 4 illustrates the temperature dependency of the output voltages of the power source regulator that is shown in Fig. 1.

Here, it is assumed that (VTP + VTN) = 1.4 V, the temperature coefficient of (VTP + VTN) is -3.3 mV/°C, and the temperature coefficient of the channel conductance $\beta$ is the power of -1.5. In the VDD = 5 V system as shown in Fig. 4, the voltage changes from 4.6 V to 5.4 V at a positive temperature gradient over a temperature range of from -40°C to 90°C to compensate the change in the operation speed of a digital circuit such as CMOS logic circuit. When the VDD is 2.7 V or smaller, the voltage changes at a negative temperature gradient over the temperature range of from -40°C to 90°C. The output voltage is most stable when the VDD is around 3 V. That is, the voltage VDD remains almost constant irrespective of a change in the temperature. The output voltage VB of the regulator can be variously set by changing the size of the MOSFETs Q1 and Q2 that constitute a dummy circuit or by changing the constant current Io that flows therein.

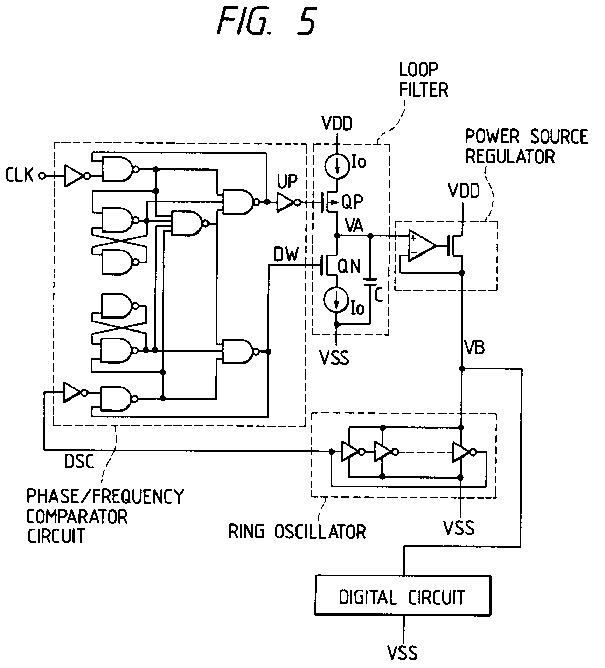

Fig. 5 is a circuit diagram illustrating a further embodiment of the present invention.

This embodiment utilizes a ring oscillator in which an odd number of inverter circuits which are the same as those used in digital circuits are connected in the form of a loop in order to monitor the operation speed of the digital circuit and the consumption of current. That is, this embodiment uses a PLL loop which generates such an operation voltage VB that makes the frequency of oscillation signals OSC of the ring oscillator constant.

The ring oscillator consists of the same inverter circuits as those used in digital circuits and an odd number of inverter circuits are connected in series in the form of a ring. The oscillation output OSC of the ring oscillator is fed to one input of a phase/frequency comparator circuit which receives at the other input terminal thereof reference frequency signals CLK. The phase/frequency comparator circuit generates an up UP or down DW output signal having a pulse width which corresponds to a phase difference (frequency difference) between the above two signals OSC and CLK. Fig. 5 shows a logic circuit of a concrete example in which the phase/frequency comparator circuit is the one that is extensively used in a PLL circuits or digital PLL circuits and is not described here in detail since it has no direct relationship to the present invention.

The up output UP and the down output DW of the phase/frequency comparator circuit are inputted into the next loop filter and are converted into DC voltages. The up output UP is fed to the gate of the p-channel switching MOSFET QP that constitutes the loop filter and the down output DW is fed to the gate of the n-channel switching MOSFET ON. The source sides of the switching MOSFETs QP and QN are provided with a constant current source Io, respectively. The constant-current source Io provided on the source side of the p-channel switching MOSFET QP can be regarded to supply a push-out constant current and the constant-current source Io provided on the source side of the n-channel switching MOSFET QN can be regarded to supply a sink constant current. Here, the constant current of the constant-current source Io does not mean to be the same as the constant current Io that is fed to the above-mentioned dummy circuit but is used to represent a general constant-current source. A capacitor C is provided for the common drain of the switching MOSFETs QP and QN. The voltage held by the capacitor C serves as a DC voltage VA that corresponds to the output signal of the phase/frequency comparator circuit.

The DC voltage VA is amplified through the power source regulator consisting of the operational amplifier circuit and the source follower MOSFET like the one used in the embodiment of Fig. 2 so as to be used as an operation voltage VB for the ring oscillator and as an operation voltage for the digital circuit that is shown by a black box.

The power source regulator may be an operational amplifier circuit itself in the form of a voltage follower by omitting the output MOSFET. Furthermore, the power source regulator of Fig. 5 may be used exclusively for the ring oscillator and the digital circuit may be provided with a similar power source regulator which receives the above voltage VA or VB. In this case, a digital circuit, when it is of a large scale, may be divided into a plurality of circuit blocks which are then provided with power source regulators, respectively. This holds true even in the embodiment of Figs. 1 and 2.

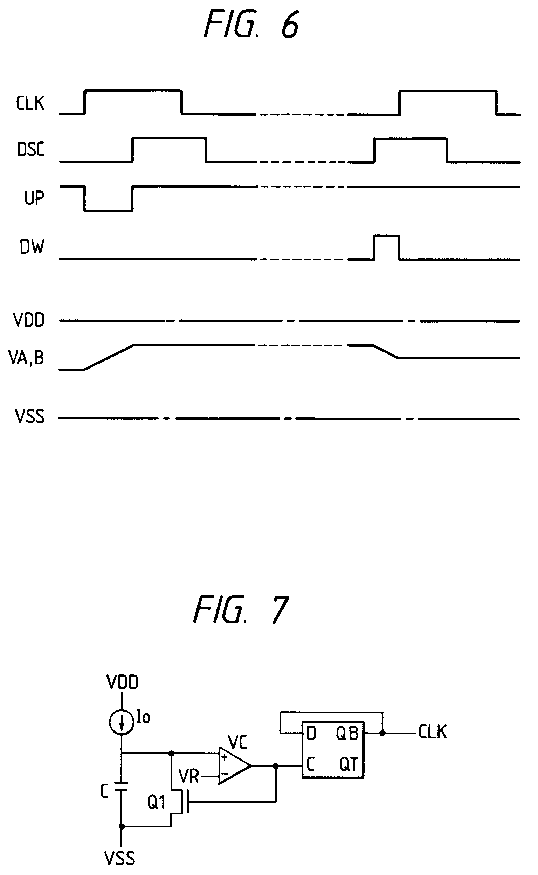

Fig. 6 is a diagram or waveforms for explaining the operation of the PLL loop. When the phase of the oscillator output OSC lags behind the reference frequency signal CLK (when the frequency is low), the phase/frequency comparator circuit detects the lag and forms an up signal UP having a pulse width that corresponds to the difference of phase. During the period in which the up signal UP is at a low level, the p-channel switching MOSFET QP is on whereby the constant current Io flows into the capacitor C to charge it up. The voltage VA of the capacitor C then rises. The operation voltage VB of the ring oscillator rises with the rise in the voltage VA. As a result, an increased current flows in the inverter circuits that constitute the ring oscillator causing the frequency of oscillation outputs OSC to increase. In order to simplify the drawing, Fig. 6 simply shows that the reference frequency CLK and the frequency of oscillation outputs OSC are equalized at a time by the phase comparison output. In order to stabilize the operation, however, the loop gain is set relatively small, and consequently the voltage VA is gradually changed plural times by phase comparison outputs.

When the phase of the oscillation output OSC leads ahead of the reference frequency signal CLK due to, for example, a change in the temperature, the phase/frequency comparator circuit detects this lead and generates a down signal DW having a pulse width that corresponds to the difference of phase. During the period in which the down signal DW is at a high level, the n-channel switching MOSFET QN is on, so that the capacitor C is discharged starting with the constant current Io. Therefore, the voltage VA of the capacitor C decreases. The operation voltage VB of the ring oscillator decreases, too, with the decrease in the voltage VA. As a result, a reduced current flows into the inverter circuits constituting the ring oscillator causing the frequency of oscillation outputs OSC to decrease.

As described above, the voltages VA and VB change little when the PLL is under a locked condition, and the operation voltage VB is so controlled that the oscillation output OSC of the ring oscillator is in agreement with the reference frequency CLK.

In this embodiment, the operation speed of the dummy circuit is directly monitored, and the operation speeds of the logic gate circuits such as of the inverter circuits in the digital circuit are stabilized, corresponding to the signal delay time of the inverter circuits in the ring oscillator. As the operation speed of the digital circuit is stabilized, therefore, the consumption of electric power is stabilized, too.

Fig. 7 is a circuit diagram illustrating an example of a reference frequency signal generating circuit.

The reference frequency CLK may be obtained by utilizing clock pulses such as system clocks supplied from an external unit to operate the digital circuit, by using reference frequency signals formed by a quartz oscillator circuit provided on the outside, or by incorporating a reference frequency signal generating circuit in a semiconductor integrated circuit device as in this embodiment. Fig. 7 shows an example of a reference frequency signal generating circuit provided in the semiconductor integrated circuit device.

The capacitor C is electrically charged with the constant current supplied by the constant-current source Io. A switching MOSFET Q1 for discharge is provided in parallel with the capacitor C. The voltage for charging the capacitor C is fed to the non-inverting input ( + ) of the voltage comparator circuit VC. A reference voltage VR is fed to the inverting input (-) of the voltage comparator circuit. The output signal of the voltage comparator circuit is fed to the clock terminal C of a flip-flop. A reference frequency signal CLK is generated from the inverting output QB of the flip-flop and is fed back to the data terminal D. Thus, the flip-flop constitutes a frequency-dividing circuit and is inverted every time the charging voltage of the capacitor C reaches the reference voltage VR thereby to form reference frequency signals CLK having a pulse duty of 50%.

When a charging voltage of the capacitor C reaches the reference voltage VR, the output signal of the voltage comparator circuit goes to a high level, the flip-flop is inverted in synchronism with the leading edge thereof, and the switching MOSFET Q1 for discharge is turned on to discharge the capacitor C. Theoretically, in this case, when the voltage held by the capacitor becomes smaller than the reference voltage VR because of the discharge of the capacitor C, the switching MOSFET Q1 is turned off and the charging operation is resumed again. In practice, however, the delay in the operation of the voltage comparator circuit and the delay in the operation of the switching MOSFET Q1 are utilized, and the time constant of the ON resistance of MOSFET Q1 and of the capacitor C is set to be smaller than the above operation delays, so that the capacitor C is completely discharged after the charging voltage of the capacitor C has once reached the reference voltage VR. This makes it possible to supply a stable constant current Io by compensating the temperature and to supply stable oscillation frequency signals in correspondence with the capacitance of the capacitor C and the reference voltage VR. It is further allowable to externally provide a quartz oscillator or a ceramic oscillator in order to obtain a stable oscillation frequency.

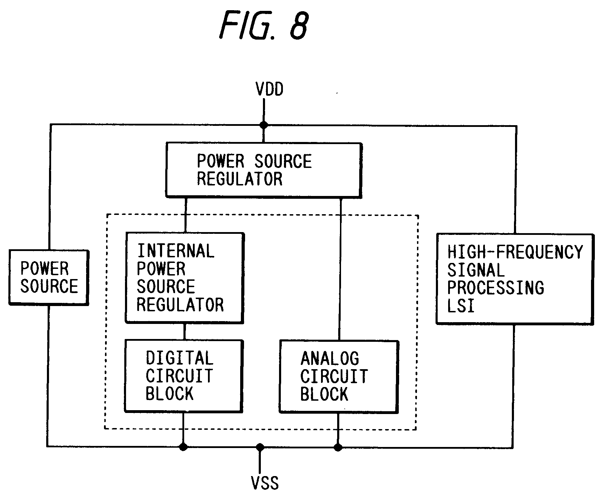

Fig. 8 is a block diagram illustrating an example of a signal processing apparatus according to the present invention.

Though there is no particular limitation, the signal processing apparatus of this example is designed for use in mobile cordless communication devices. The power source includes a battery for portable purposes and is constituted, for example, by a secondary cell and a charging circuit therefor.

The high-frequency signal processing LSI executes signal processings for transmission and for reception, and is constituted by a high-speed high-power circuit fabricated by using bipolar transistors and MESFETs such as of GaAs. Such a high-frequency signal processing LSI is served with an operation voltage directly from a power source of this type.

In order to reduce the power consumption of the device, the power source regulator converts a relatively high voltage generated by the power source in accordance with the operation of the high-frequency signal processing LSI into a relatively low voltage which corresponds to the operation of the internal analog signal processing circuit and the digital signal circuit. The analog circuit block which effects the analog signal processing is operated on an internal voltage produced by the power source regulator since the consumed current is stable owing to the contrivance of the bias circuit as mentioned above. In the digital circuit block which effects the digital signal processing such as CMOS circuits, on the other hand, the internal power source regulator is provided as shown in Figs. 1 and 2 to stabilize the consumed current and to stabilize the speed of operation, or a power source regulator as shown in Fig. 5 is provided to stabilize the consumption of current by the stabilization of the operation speed.

The above-mentioned analog circuit block and the digital circuit block may be constituted by using one or more semiconductor integrated circuit devices, respectively, or may be constituted by using a single semiconductor integrated circuit device and in which the digital circuit block only may be served with the operation voltage from an internal power source regulator.

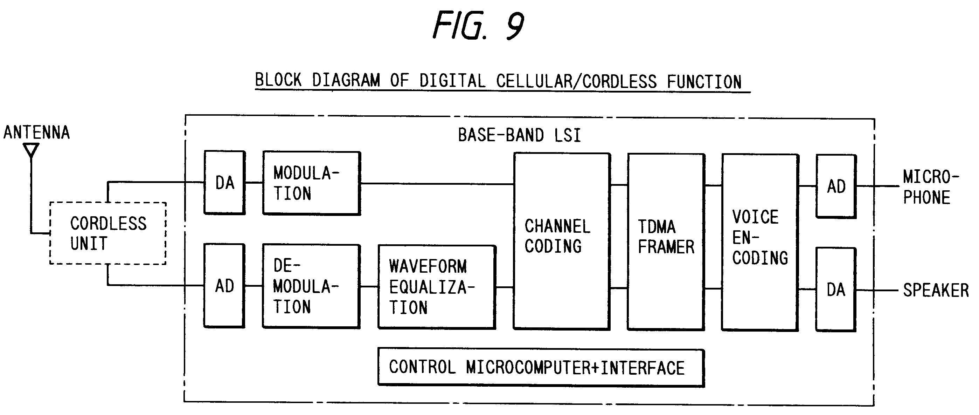

Fig. 9 is a block diagram of an example of major portions of a digital cordless telephone set to which the present invention is applied.

This invention is applied to a base band LSI (large-scale semiconductor integrated circuit device). That is, a voice signal from a microphone (transmitter) is converted into a digital signal through an analog/digital converter circuit AD and is digitally encoded through a voice encoding unit which further decodes the digitally encoded voice signal and transmits it to a speaker (receiver) through a digital/analog converter circuit DA. Thus, the voice encoding unit constitutes a encoder/decoder (CODEC). In ordinary cordless telephone sets, digital signals are encoded (compressed) by an ADPCM.

The TDMA (framer) unit performs time division multiplexing of a plurality of channels such as three channels or six channels. In the case of three channels, for instance, there can be provided up to three child devices. A channel encoding unit inserts an error correction code, performs scrambling operation to prevent wiretap and enciphering operation, and operates various bits such as maintenance bits and protocols. A modulation unit modulates the digital signals to be transmitted, outputs them via a digital/analog converter circuit DA, and transmits them to a cordless unit which performs the high-frequency signal processing to transmit signals in the form of electromagnetic waves from an antenna. The signals received in the form of electromagnetic waves through the antenna are then received by the radio unit, and are input to the analog/digital converter circuit DA where they are digitally coded. The signals are then decoded into the initial digital voice signals through a channel encoding unit, TDMA unit and voice coding unit, and are transmitted to the speaker via a digital/analog converter circuit DA.

The above-mentioned circuit blocks are controlled by a microcomputer and an interface unit thereof.

In the base band LSI, the circuit block constituted by digital circuits such as of CMOS circuits, excluding analog circuits such as an analog/digital converter circuit AD and a digital/analog converter circuit DA, is provided with a power source regulator as shown in Figs. 1, 2 or 5 to generate an operation voltage thereof. This makes it possible to control the operation current to be constant even when use is made of MOSFETs having large process variance and temperature dependency. Therefore, the capacity of the battery to be used can be determined on the basis of the temperature characteristics thereof. In other words, since the relationship that the temperature dependency on the side of the CMOS circuit conflicts with the temperature dependency of the battery is excluded as described before, it is allowed to set the power source by taking the temperature dependency on the battery side only into consideration. This, in other words, means that the current consumed by the CMOS circuit is suppressed from increasing when the temperature becomes low, enabling the life of battery to be lengthened correspondingly. Alternatively, if the battery life is left as it is, it is allowed to use a battery having a small capacity, resulting in gaining an additional advantage of reduction in the weight of the device.

The following operations and effects are exhibited by the aforementioned embodiments.

(1) According to the voltage which is obtained by allowing a current to flow in a dummy circuit equivalent to a digital circuit, or according to the output of a phase/frequency comparator circuit, the operating voltage of a ring oscillator having an inverter circuit equivalent to the digital circuit is so generated that the oscillation frequency of the ring oscillator is equal to a reference frequency. The digital circuit is operated on this operating voltage. Therefore, the consumption of electric power by the digital circuit is optimized and the operation thereof is stabilized irrespective of a change in the temperature.

(2) In the constitution of causing a constant current to flow by using as a dummy circuit the CMOS inverter circuit whose input and output are connected together, the load capacitance of the digital circuit is of a fixed one such as the wiring capacitance or gate capacitance. Therefore, the operation speed of the digital circuit is determined by a change in the through current, and the operation speed or the operation current of the digital circuit is controlled to become constant using a simply constructed circuit.

(3) A signal processing device driven by a battery is constituted by using a semiconductor integrated circuit device having a digital circuit in which the operation current can be controlled to be constant as described in (1) above, whereby the conflicting relationship that the temperature dependency on the side of the digital circuit conflicts with the temperature dependency of the battery is substantially eliminated as described above, and the power source is set by taking into consideration the temperature dependency of the battery side only.

(4) The consumption of current by the digital circuit is suppressed from increasing when the temperature becomes low as described in (3) above, enabling the life of the battery to be prolonged. When the battery life is left as it is, then it is allowed to use a battery of a small capacity.

In the foregoing has been concretely described the invention accomplished by the present inventors by way of embodiments. It should, however, be noted that the invention is in no way limited to the above embodiments only but can be modified in a variety of ways without departing from the gist and scope of the invention. In the embodiment of Fig. 1, 2 or 5, for instance, when the digital circuit is a so-called ratio-type logic circuit that uses enhancement-type load MOSFETs or depletion-type load MOSFETs instead of the CMOS circuit, this digital circuit should be used as a dummy circuit. Moreover, the constant-current circuit that supplies a constant current into the dummy circuit and the voltage follower circuit that amplifies and transmits the voltage generated by the dummy circuit to the digital circuit, may be constituted in a variety of other ways.

The semiconductor integrated circuit device of the present invention which is featured by a constant current consumption irrespective of a change in the temperature can be used in a signal processing system which has a features that the operation speed is constant irrespective of a change in the temperature and that the system is powered by a battery. Or, the semiconductor integrated circuit device may be used in a signal processing system which is desired to consume a constant current to generate constant heat since the heat generates with an increase in the consumption of current. As described above, the semiconductor integrated circuit device of the present invention having a digital circuit that operates at a constant speed and that consumes a constant current can be extensively utilized in a variety of signal processing devices.

Briefly described below are the effects obtained by a representative example of the invention disclosed in this application. According to the voltage which is obtained by allowing a current to flow in a dummy circuit equivalent to a digital circuit, or according to the output of a phase/frequency comparator circuit, the operating voltage of a ring oscillator having an inverter circuit equivalent to the digital circuit is so generated that the oscillation frequency of the ring oscillator is equal to a reference frequency. The digital circuit is operated on this operating voltage. Therefore, the consumption of electric power by the digital circuit is optimized and the operation thereof is stabilized irrespective of a change in the temperature. Moreover, the signal processing device driven by a battery is constituted by using a semiconductor integrated circuit device having a digital circuit which is capable of controlling the operation current to be constant, and whereby the conflicting relationship that the temperature dependency on the side of the digital circuit conflicts with the temperature dependency of the battery is substantially eliminated as described above. Therefore, the power source can be set by taking into consideration the temperature dependency of the battery side only.

## Claims

1. A semiconductor integrated circuit device having a power source circuit which controls the operation voltage of a digital circuit on the basis of a voltage that is obtained by permitting a constant current to flow in a dummy circuit that is equivalent to said digital circuit.

2. A semiconductor integrated circuit device according to claim 1, wherein said dummy circuit is a CMOS inverter circuit whose input and output are connected together, and the digital circuit is constituted by a CMOS circuit.

3. A semiconductor integrated circuit device according to claim 2, wherein said constant current does not depend substantially on a change in the power source voltage, a change in the temperature, or a change in the threshold voltage of the MOSFETs.

4. A semiconductor integrated circuit device comprising:

a ring oscillator constituted by using inverter circuits equivalent to a digital circuit;

a phase/frequency comparator circuit that receives the oscillation frequency of said oscillator and a reference frequency;

a power source circuit which so controls the operation voltage on the basis of the output of said phase/frequency comparator circuit that the oscillation frequency of the ring oscillator is nearly equal to the reference frequency; and

a digital circuit which is operated by the operation voltage of the ring oscillator or by an operation voltage based thereupon.

5. A signal processing device comprising:

a semiconductor integrated circuit device having a power source circuit which controls the operation voltage of a digital circuit on the basis of a voltage that is obtained by permitting a constant current in a dummy circuit equivalent to said digital circuit; and

a power source that is operated by a battery incorporated therein.

6. A signal processing device comprising:

a semiconductor integrated circuit device which is provided with a ring oscillator constituted by using inverter circuits equivalent to a digital circuit, a phase/frequency comparator circuit that receives the oscillation frequency of said oscillator and a reference frequency, a power source circuit which so controls the operation voltage on the basis of the output of said phase/frequency comparator circuit that the oscillation frequency of the ring oscillator is nearly equal to the reference frequency, and a digital circuit which is operated by the operation voltage of the ring oscillator or by an operation voltage based thereupon; and

a power source that is operated by a battery incorporated therein.

7. A signal processing device according to claim 6, wherein said signal processing device performs digital signal processing and analog signal processing.

## FIG. 1

## FIG. 2

## FIG. 3

## FIG. 4

# FIG. 5

LOOP
FILTER

POWER SOURCE
REGULATOR

VDD

VDD

Io

QP

VA

UP

DW

QN

Io

C

VSS

VB

CLK

DSC

PHASE/FREQUENCY
COMPARATOR
CIRCUIT

RING OSCILLATOR

VSS

DIGITAL CIRCUIT

VSS

# FIG. 6

CLK

DSC

UP

DW

VDD

VA,B

VSS

# FIG. 7

VDD

Io

VC

D    QB — CLK

C    QT

VR

C

Q1

VSS

# FIG. 8

VDD

POWER SOURCE
REGULATOR

POWER
SOURCE

INTERNAL
POWER
SOURCE
REGULATOR

HIGH-FREQUENCY
SIGNAL
PROCESSING
LSI

DIGITAL
CIRCUIT
BLOCK

ANALOG
CIRCUIT
BLOCK

VSS

## FIG. 9

### BLOCK DIAGRAM OF DIGITAL CELLULAR/CORDLESS FUNCTION

BASE-BAND LSI

ANTENNA

CORDLESS UNIT

DA — MODULATION

AD — DEMODULATION — WAVEFORM EQUALIZATION

CHANNEL CODING

TDMA FRAMER

VOICE ENCODING

AD — MICROPHONE

DA — SPEAKER

CONTROL MICROCOMPUTER+INTERFACE

EP 0 517 375 A2